Europäisches Patentamt

European Patent Office

Office européen des brevets

(11) Publication number: **0 290 648 B1**

# EUROPEAN PATENT SPECIFICATION

(45) Date of publication of patent specification: **11.03.92**   (51) Int. Cl.⁵: **G01L 1/08**, G01L 1/14

(21) Application number: **87106900.1**

(22) Date of filing: **12.05.87**

(54) **Atomic force sensor head for investigating the topography of a surface.**

(43) Date of publication of application:
**17.11.88 Bulletin 88/46**

(45) Publication of the grant of the patent:
**11.03.92 Bulletin 92/11**

(84) Designated Contracting States:
**CH DE FR GB LI**

(56) References cited:
**GB-A- 2 150 304**

**PHYSICA, vol. 24, 1958, pages 751-764, Amsterdam, NL; M.J. SPARNAAY: "Measurements of attractive forces between flat plates"**

**PHYSICAL REVIEW LETTERS, vol. 56, no. 9, 3rd March 1986, pages 930-933, New York, US; G. BINNIG et al.: "Atomic force microscope"**

**JOURNAL OF APPLIED PHYSICS, vol. 57, no. 5, 1st March 1985, pages 1437-1444, American Institute of Physics, New York, US; J.R. MATEY et al.: "Scanning capacitance microscopy"**

**NATURE, vol. 272, no. 5651, March 1978,**

**pages 313-318, Basingstoke, GB; B.V. DERJAGUIN et al.: "Direct measurement of molecular forces"**

(73) Proprietor: **International Business Machines Corporation**
**Old Orchard Road**
**Armonk, N.Y. 10504(US)**

(72) Inventor: **Dürig, Urs Theodor, Dr.**
**Alte Landstrasse 89**
**CH-8803 Rüschlikon(CH)**
Inventor: **Gimzewski, James Kazimierz, Dr.**
**Seefeldstrasse 112**
**CH-8008 Zürich(CH)**
Inventor: **Rohrer, Heinrich, Dr.**
**Bachtelstrasse 27**
**CH-8805 Richterswil(CH)**

(74) Representative: **Rudack, Günter O., Dipl.-Ing.**
**IBM Corporation Säumerstrasse 4**
**CH-8803 Rüschlikon(CH)**

EP 0 290 648 B1

**Description**

This invention relates generally to Atomic Force Microscopes (AFM) and more particularly to means for measuring the forces and/or deflections occurring during operation of the AFM when investigating the topography of a surface.

The Atomic Force Microscope proposed by G. Binnig in EP-A-0 223 918 and described by G. Binnig, C.F. Quate and Ch. Gerber, Phys. Rev. Letters, Vol.56, No.9, March 1986, pp.930-933, employs a sharply pointed tip attached to a spring-like cantilever beam to scan the profile of a surface to be investigated. At the distances involved, minute forces occur between the atoms at the apex of the tip and those at the surface, resulting in a tiny deflection of the cantilever. In Binnig's proposal, this deflection is measured by means of a tunneling microscope, i.e., an electrically conductive tunnel tip is placed within tunnel distance from the back of the cantilever beam, and the variations of the tunneling current are used to determine the deflection. With known characteristics of the cantilever beam, the forces occurring between the AFM tip and the surface under investigation can be determined.

The forces occurring between a pointed tip and a surface are usually described as van-der-Waals, covalent, ionic, or repulsive core interaction forces. The energies involved in the atomic distance approach between single atoms respectively at the apex of the tip and on a surface are in the range of $E_0 = 0,01...10eV = 10^{-22}...10^{-18}$ Joule. The corresponding distances are in the subnanometer range of $X_0 = 10...1000$ pm $= 0,01...1$ nm. The respective forces (i.e. the first derivatives of the potential function, therefore, are in the range of $K_0 = 10$ pN ... 10 nN. The resulting atomic 'spring constants', i.e., the second derivatives of the potential function are in the range of $C_0 = 100...0,01$ N/m. These data can be deduced from surface studies and many other sources, such as the values of elastic constants.

Experiments with van-der-Waals forces are reported in M.J. Sparnaay, "Measurements of Attractive Forces Between Flat Plates", Physica XXIV (1958) pp. 751-764. Fig. 2 of this reference shows a setup comprising a cantilever beam fixed at one end and bearing at half-length one plate of a pair of parallel plates, the other plate of which is mounted independent of the cantilever beam. The weight of the beam is balanced by a spring, and the deflection the beam undergoes upon interaction of the pair of plates is determined by the variation of a capacitor having one of its plates attached to the cantilever beam, while the other plate is fixed.

It is one object of the present invention to describe several embodiments of an atomic force measuring device which uses techniques alternative to funneling, while keeping the cantilever as a force/deflection translator. The devices in accordance with the invention can be used as atomic force microscopes, but they may also find a wider field of application once available.

The present invention accordingly contemplates to teach an atomic force sensor head of the type having at least one cantilever beam fixed at one end and carrying an interaction member in a location distant from said fixed end for interaction with the surface of a sample the topography of which is to be investigated, and means for detecting the deflection of said cantilever beam as said interaction member interacts with the surface of said investigated sample. Said detection means are designed to convert said deflection of said cantilever beam from its home position into a variation of an electrical value other than a tunneling current, from an initial value thereof. This atomic force sensor head is characterized in that said interaction member consists of a pointed tip rigidly fixed on said cantilever beam and supported at a distance of the order of one nanometer from the surface to be investigated, that said detection means is designed as a capacitor comprising a pair of capacitor plates of which a first one forms an integral part with said cantilever beam while the second plate is mounted stationary opposite said first plate at one arm of a frame member, that both plates of said capacitor are connected to conventional capacitance measurement equipment, and that the output signal of said capacitance measurement equipment, representing a variation of the capacitance of said capacitor from an initial capacitance value, is supplied via a feedback control circuit to a z-drive for adjusting the z-distance of said tip from the surface of the sample being investigated.

Details of several embodiments of the invention will be described by way of example in the following description and with reference to the attached drawings in which:

Fig. 1    is a schematic diagram of an atomic force microscope using a capacitor as the deflection detector;

Fig. 2    shows a micromechanical embodiment of the capacitive force sensing head:

Fig. 3    shows an extension of the embodiment of Fig. 2, employing a piezoelectric transducer;

Fig. 4    shows another extension of the embodiment of Fig. 2 with a high-dielectric-constant material.

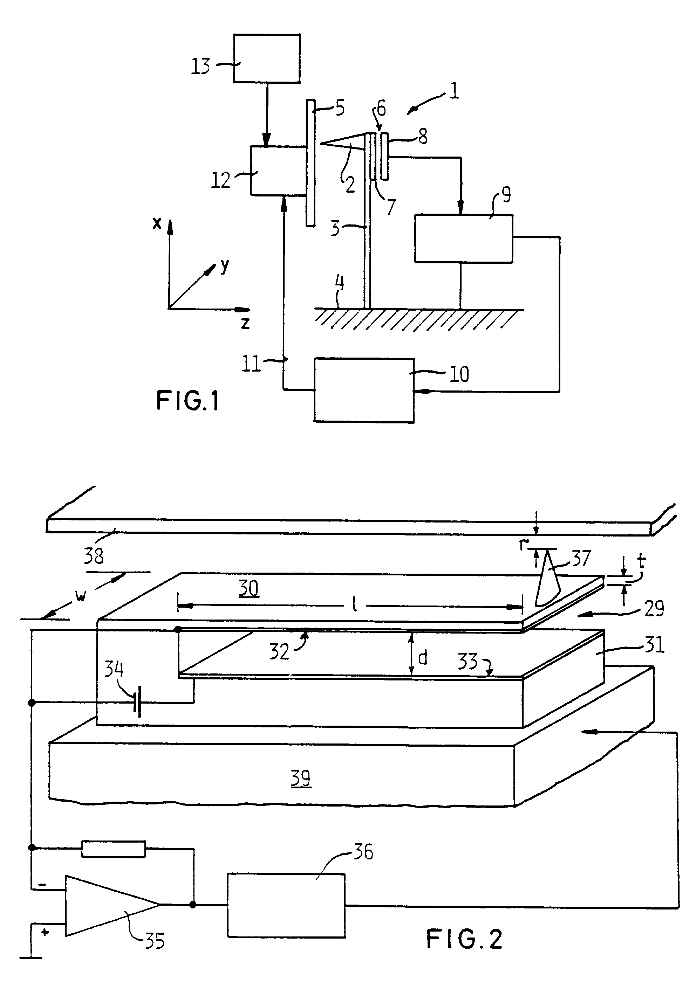

Referring to Fig. 1, there is shown an atomic force microscope 1 comprising a sharply pointed tip 2, which may, for example, consist of diamond, and which is attached to a cantilever beam 3 that rests on a base plate 4. As a sample 5 to be investigated is approached to tip 2, the forces occurring between the closest atoms at tip 2 and sample 5 will cause a deflection of cantilever beam 3. Assuming the said forces are repulsive, as they normally are, cantilever beam 3 will be deflected toward the right in Fig, 1. The amount of deflection is on the order of $10^{-11}$ m.

At its top, where the deflection is greatest, cantilever beam 3 forms one plate of a capacitor 6. For this purpose, cantilever beam 3 may either be made of an electrically conductive material, or carry a conductive coating at its upper end. The second plate 8 of capacitor 6 is arranged opposite coating 7/cantilever beam 3 at a very small distance. In Fig. 1, cantilever beam 3 is connected to ground, and capacitor plate 8 is connected to a conventional capacitance measurement device 9, which may be, for example, an AC Wheatstone bridge.

At rest, the capacitance meter 9 is adjusted such that its output is zero. As cantilever beam 3 is deflected under the influence of a force exerted on its tip 2, the capacitance is varied, and an output signal is generated from capacitance meter 9. This output signal is used by a feedback circuit 10 to generate a control signal on line 11 which is fed to the z-part of an xyz-drive 12. This z-part is responsible for controlling the distance between the surface of sample 5 and the apex of tip 2. (The x- and y-parts of xyz-drive 12 control the matrix-scanning of tip 2 across the surface of sample 5 under the direction of an xy-control unit 13.)

State-of-the-art capacitance meters can measure capacitance changes as small as $\Delta C = 10^{-18}$ F (attofarad), using techniques as described, for instance, by J.R. Matey and J. Blanc, J.Appl. Phys., 57, p. 1437 (1985). This sensitivity can be employed to measure changes in distance or dielectric constant in accordance with the parallel plate capacitor formula $C = \epsilon A/d$, where $\epsilon$ is the dielectric constant, A is the plate area, and d is the plate separation. For a plate area of 100 by 100 micrometers and a plate separation of 1 micrometer, in air a capacitance of about $2 \cdot 10^{-13}$ F results. The sensitivity mentioned above hence translates into a minimum detectable gap width variation of $\Delta d = (d/C) \cdot \Delta C = 10^{-11}$ m.

Fig. 2 shows an embodiment of the force sensing head in which the tip-carrying cantilever beam 30 is arranged opposite a rigid body 31 acting as a solid base. Preferably, cantilever beam 30 and body 31 are manufactured from one piece of $Si/SiO_2$ by well known micromechanical techniques. The mutually facing surfaces of cantilever beam 30 and body 31 are respectively coated with thin gold layers 32 and 33, thus forming a capacitor 29, to which a voltage source 34 is connected. The gold layer 32 of cantilever beam 30 is also connected to an amplifier 35. The output terminal of the latter is connected to a discriminator 36.

As the tip 37 is approached to the surface of the sample 38, the nearmost atoms at tip and surface interact, developing a force between them which is determined by their interaction potential $U_{int}$, their distance r, and the spring constant C of cantilever beam 30. In equilibrium, i.e., when the atomic force $dU_{int}/dr$ balances the spring force C x, the deflection of cantilever beam 30 is given by:

$$U_{int} + \frac{1}{2} C x^2 = Min.$$

The embodiment of Fig. 2 may be adjusted to yield a static deflection $x \simeq 10 \ldots 100$ pm which can be detected statically. Cantilever beam 30 also is a harmonic oscillator with an eigenfrequency $\omega_0$. In the presence of the said atomic interaction, the resonance frequency of cantilever beam 30 is shifted in accordance with

$$\omega^2 = \omega_0^2 \left( 1 + \frac{1}{C} \ \frac{d^2 U_{int}}{dr^2} \right).$$

This term assumes that higher-order terms of the interaction potential do not contribute to the equation of motion. The measurement of the frequency shift has the great advantage of eliminating the length measurement, resulting in simplified calibration of the sensor head.

The design of this sensor head has to be optimized with regard to opposing requirements: For the sake of high sensitivity, a weak spring constant C is desirable. However, the maximum tolerable amplitude of the thermal vibrations of the arrangement poses a lower limit. Furthermore, C should be larger than the maximum of $d^2U_{int}/dr^2$, lest metastable equilibrium positions should exist, rendering reliable operation of the sensor head impossible. This might become a severe problem in the case of the short-range covalent

EP 0 290 648 B1

binding interaction where second derivatives of the potential of the order of 10...100 N/m are to be expected. Accordingly, a rather stiff cantilever beam is desirable.

The micromechanical cantilever beam 30 in accordance with the present invention provides an optimum performance. Its resonance frequency is monitored by measuring the capacitive current which is introduced by thermal vibrations on the beam. In a feedback loop, the natural vibration amplitude of the beam can be increased to thereby enhance the sensitivity of the sensor head. This provides a convenient way to adapt the properties of the sensor head to the particular form of the interaction potential. For example, at large tip/sample distance, where the interaction is weak, the required high sensitivity is achieved by increasing the vibration amplitude to about one nanometer. As the interaction becomes stronger upon the tip approaching the surface, the beam vibration can be decreased to avoid touchdown to the surface.

Referring again to Fig. 2, oscillations of cantilever beam 30 cause capacitance variations which give rise to a corresponding AC current. This current is amplified by an amplifier 35, and the frequency of the oscillations is measured by standard techniques. Body 31 may be mounted on a conventional xyz-drive (not shown) for approaching tip 37 to the surface of sample 38, and for scanning the tip across that surface.

To permit detailed investigation of the weak attractive forces between two atoms, i.e., the second derivative of the interaction potential $C_{int} = d^2U_{int}/dr^2$, the embodiment of Fig. 2 should be dimensioned in accordance with the following considerations:

The second derivative $C_{int}$ of the interaction potential $U_{int}$ and the measured frequency shift $\Delta\omega$ are related as follows:

$$C_{int} = 2\, C_{eff}\ \frac{\Delta\omega}{\omega_0}\ ,$$

where $C_{eff}$ is approximately equal to the static spring constant of cantilever beam 30. The detection threshold $C_{min}$ can be expressed in terms of the eigenfrequency $\omega_0$, the Q factor of the resonator, and the integration time $\tau$ of the frequency measurement:

$$C_{min} = 2\ \frac{C_{eff}}{\sqrt{Q\omega_0\tau}}\ .$$

$C_{min}$ is chosen at 0.01 N/m; a Q factor of 1000 for a micromechanical cantilever beam has recently been established: the integration time $\tau$ must not exceed 10 ms in order to allow for constant force scanning microscopy in addition to the measurement of the interaction potential $U_{int}$; and the eigenfrequency $\omega_0$ should be about $2\pi$ x 10kHz in order to allow adequate isolation from ambient vibrations. With these parameters, one obtains $C_{eff} = 4$ N/m and a detector sensitivity of 1,25 kHz/(N/m). In other words, a $C_{min}$ of 0,01 N/m gives rise to a frequency shift of 12,5 Hz. The rms amplitude of the thermal vibrations is 0,016 nm at liquid nitrogen temperature and 0,03 nm at room temperature.

Terms of the interaction potential $U_{int}$ of an order greater than 3 give rise to an additional frequency shift proportional to the square of the vibration amplitude. This frequency shift causes an ambiguity $C_{ah}$ of the measured $C_{int}$ of the order of

$$C_{ah} < \frac{1}{8}\ \left|\frac{d^4U_{int}}{dr^4}\right|\ x_{th}^2.$$

Considering the fact that $C_{eff} = K \cdot f_R$, with K being a constant close to unity, the dimensions for cantilever 30 can be calculated from the following equations for the force constant $f_R$ and for the resonant frequency $\omega_0$ :

4

$$f_R = \frac{1}{4} \; E \; \frac{w \, t^3}{l^3}$$

$$\omega_0 = 1,02 \left( \frac{E}{\rho} \right)^{\frac{1}{2}} \frac{t}{l^2} \; ,$$

wherein $E = 7,2 \times 10^{10}$ N/m$^2$ is Young's modulus of elasticity for $SiO_2$, w, t and l are respectively width, thickness and length of cantilever 30, and $\rho = 2,2 \times 10^3$ kg/m$^3$ is the specific density of the cantilever material. With the parameters indicated above and with the realistic assumption that w should equal 8t, the dimensions of the cantilever beam result as w = 115$\mu$m, t = 14$\mu$m, and l = 1150$\mu$m.

Choosing a spacing d of 10 $\mu$m between gold layers 32 and 33, the capacitance becomes $C_b = 0,12$pf. The induced AC current I is:

$$I = V \, \frac{dC_b}{dt} = 0,392 \, C_b \, \omega_0 \, x_{th} \, \frac{V}{d} \; .$$

With a potential V = 50V, one obtains a rms current of 0,25 pA. Currents of this order of magnitude can be detected with conventional FET amplifiers.

The electric field existing between gold electrodes 32 and 33 exerts an additional force on the cantilever beam, increasing its $C_{eff}$ by a factor k

$$k = \sqrt{1 + C_b \, \frac{V^2}{m \, \omega_0^2 \, d^2}} \; ,$$

wherein m is the mass of cantilever beam 30. In this particular example, the factor $k \approx 1,1$.

An important extension of the embodiment of Fig. 2 is the incorporation of feedback to increase the natural vibration amplitude of the cantilever beam. This will enhance the sensitivity of the sensor head and open further fields of applicability.

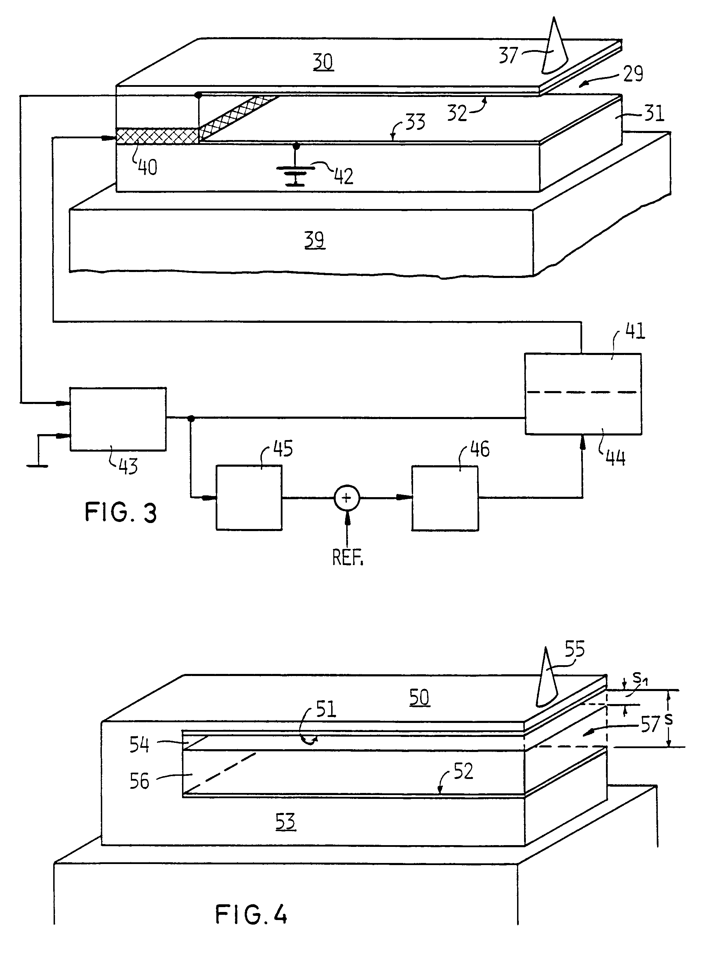

Fig. 3 shows one way of implementing a feedback loop in a micromechanical sensor head. The same as in the embodiment of Fig. 2, cantilever beam 30 carries an electrode 32 and is arranged opposite body 31 which carries its electrode 33. Cantilever beam 30 is mounted on top of a piezoelectric transducer 40 which rests on body 31. Transducer 40 can be excited by the output signal from an excitation unit 41. A voltage source 42 is connected between electrode 33 and ground, and electrode 32 is connected to the input terminal of an I/V converter 43. The output signal of the latter controls a fast-controllable gain amplifier 44 and, via rectifier 45 and with the addition of a fluctuation amplitude reference signal, a slow-controllable feedback amplifier 46 which supplies a gain control signal to gain amplifier 44.

Fig. 4 shows a modification of the embodiments described in connection with Figs. 2 and 3. An insulating layer 56 with high dielectric constant fills part of the gap between the electrodes 51 and 52. This has a threefold beneficial effect:

- The electrodes cannot touch one another and cause a shortcircuit.
- The deflection of the cantilever beam is stable within the remaining free gap 54 between the electrodes.
- The sensitivity is enhanced if the dimensions are chosen appropriately.

The arrangement of Fig. 4 is essentially the same as described before, with the exception that the gap between electrode 51 carried by cantilever 50 and counterelectrode 52 resting on body 53 is filled with two (or more) dielectric materials having different dielectric constants $\epsilon_r$. Preferably, the dielectric material 54 arranged next to cantilever beam 50 should be extremely flexible, so as not to impair the movements of the cantilever beam 50 caused by the tip 55 coming close to the surface to be investigated. The obvious material is air having a dielectric constant $\epsilon_1 = 1$.

The other dielectric material 56 being disposed away from cantilever beam 50 should have a dielectric

constant $\epsilon_2$ much higher than that of the dielectric material 54, say by a factor of 10.

The arrangement of Fig. 4 actually constitutes a series connection of two capacitors with a total capacitance C of:

$$C = \frac{\varepsilon_0 A}{s} \; \frac{\varepsilon_2}{1 + \dfrac{s_1}{s}\left(\dfrac{\varepsilon_2}{\varepsilon_1} - 1\right)} \; = \; \frac{\varepsilon_0 A}{s} \; \frac{\varepsilon_2}{B},$$

wherein A is the area of the capacitor and B is indicative of the interrelation of the relative thicknesses and dielectric constants of the dielectric materials 54 and 56:

$$B \; = \; 1 + \frac{s_1}{s}\left(\frac{\varepsilon_2}{\varepsilon_1} - 1\right).$$

To determine the improvement in sensitivity, the foregoing term for C is differentiated:

$$\frac{dC}{ds_1} = - \frac{\varepsilon_0 A}{s^2}\left(\frac{\varepsilon_2^2}{\varepsilon_1} - \varepsilon_2\right)\frac{1}{B^2}.$$

With a relationship

$$\frac{s_1}{s} = 0{,}05$$

and a 1:10 relation for the dielectric constants, the sensitivity improvement by filling part of the gap s becomes:

$$F \; = \; \frac{\varepsilon_2^2 - \varepsilon_2}{B^2} \; = \; \frac{90}{2{,}1} \approx 40.$$

**Claims**

**1.** Atomic force sensor head comprising at least one cantilever beam (3, 30, 50,) fixed at one end to a frame member (4, 39, 53,) and carrying an interaction member (2, 37, 55,) in a location distant from said fixed end for interaction with the surface of a sample (5, 38) the topography of which is to be investigated, and means (6, 29,) for detecting the deflection of said cantilever beam (3, 30, 50,) as said interaction member (2, 37, 55,) interacts with the surface of said investigated sample (5, 38), wherein said detection means (6, 29,) are designed to convert said deflection of said cantilever beam (3, 30, 50,) from its home position into a variation of an electrical value, other than a tunneling current, from an initial level thereof, *characterized* in that said interaction member consists of a pointed tip (2, 37, 55,) rigidly fixed on said cantilever beam (3, 30, 50,) and supported at a distance of the order of one nanometer from the surface to be investigated, that said detection means (6, 29,) is designed as a capacitor (6, 29, 57) comprising a pair of capacitor plates (7, 8; 32, 33; 51, 52) of which a first one (7, 32, 51) forms an integral part with said cantilever beam (3, 30, 50,) while the second plate (8, 33, 52) is mounted stationary opposite said first plate (7, 32, 51) at one arm (31, 53) of a frame member, that both plates (7, 8; 32, 33; 51, 52) of said capacitor (6, 29, 57) are connected to conventional capacitance measurement equipment, and that the output signal of said capacitance measurement equipment, representing a variation of the capacitance of said capacitor (6, 29, 57) from an initial capacitance value, is supplied via a feedback control circuit (10; 35, 36: 43-46) to a z-drive (12, 39) for adjusting the z-distance of said tip (2, 37, 55,) from the surface of the sample (5, 38) being investigated.

2. Sensor head in accordance with claim 1, **characterized** in that said cantilever beam (3, 30, 50,) extends from, and forms an integral part with, a frame member an arm (31, 53) of which carries said second capacitor plate (8, 33, 52) at its free end and opposite the back of said cantilever beam (3, 30, 50,) said second plate and said cantilever beam forming a capacitor (6, 29, 57), that said cantilever beam (3, 30, 50,) has an eigenfrequency of the order of 10 kHz and an effective spring constant of about 4 N/m, a width on the order of 100 $\mu$m, a thickness of about 15 $\mu$m, and a length of the order of 1100 $\mu$m, and that the spacing of said cantilever beam (3, 30, 50,) at its free end from said arm is of the order of 10 $\mu$m.

3. Sensor head in accordance with claim 2, **characterized** in that said cantilever beam (30) is mounted on top of a piezoelectric transducer (40) which rests on said frame (31), said transducer (40) being connected to be excited by an excitation unit (41), that a voltage source (42) is connected between the capacitor plates (32, 33) carried by said cantilever beam (30) and said frame (31), respectively, that the capacitor plate (32) attached to said cantilever beam (30) is connected to one input of a current/voltage converter (43), and that the output thereof is connected to an amplifier (44) which in turn is connected to said excitation unit (41).

4. Sensor head in accordance with claim 1, **characterized** in that the gap between the plates (51, 52) of said capacitor (57) is filled with at least two dielectric materials (54, 56) having different dielectric constants ($\epsilon_1$, $\epsilon_2$) and different relative thicknesses ($s_1$; $s - s_1$), respectively.

5. Sensor head in accordance with claim 4, **characterized** in that said dielectric materials (54, 56) have dielectric constants ($\epsilon_1$; $\epsilon_2$) such that their ratio $\epsilon_1 : \epsilon_2 \leq 1 : 10$, and relative thicknesses ($s_1$; $s - s_1$), such that the ratio $s_1 : s\text{-}s_1$ is 1 : 19.

## Revendications

1. Tête de capteur de forces atomiques comprenant au moins une poutre en porte-à-faux (3,30,50) fixée, à une première extrémité, à un bâti (4,39,53) et portant un élément d'interaction (2,37,55) à un endroit distant de ladite extrémité fixe pour interaction avec la surface d'un échantillon (5,38) dont on veut étudier la topographie, et des moyens de détection (6,29) de la flexion de ladite poutre en porte-à-faux (3,30,50) lorsque ledit élément d'interaction (2,37,55) réagit avec la surface dudit échantillon étudié (5,38), dans laquelle lesdits moyens de détection (6,29) sont conçus pour convertir ladite flexion de ladite poutre en porte-à-faux (3,30,50) par rapport à sa position de repos en une variation d'une valeur électrique, autre qu'un courant d'effet tunnel, par rapport à un niveau initial de cette valeur, caractérisée en ce que ledit élément d'interaction consiste en une pointe (2,37,55) rigidement fixée sur ladite poutre en porte-à-faux (3,30,50) et supportée à une distance de l'ordre d'un nanomètre de la surface à étudier, en ce que lesdits moyens de détection (6,29) sont conçus comme un condensateur (6,29,57) comprenant deux plaques de condensateur (7,8;32,33;51,52) dont une première (7,32,51) fait partie intégrante de ladite poutre en porte-à-faux (3,30,50) tandis que la deuxième plaque (8,33,52) est montée en position fixe en face de la dite première plaque (7,32,51) sur un bras (31,53) d'un bâti, en ce que les deux plaques (7,8;32,33;51,52) dudit condensateur (6,29,57) sont connectées à un équipement usuel de mesure de capacité électrique, et en ce que le signal de sortie dudit équipement de mesure de capacité, représentant une variation de la capacité dudit condensateur (6,29,57) par rapport à une valeur de capacité initiale, est fourni par l'intermédiaire d'un circuit de commande de réaction (10;35,36;43-46) à un entraînement d'axe z (12,39) pour ajuster la distance sur l'axe z de ladite pointe (2,37,55) par rapport à la surface de l'échantillon (5,38) en étude.

2. Tête de capteur suivant la revendication 1, caractérisée en ce que ladite poutre en porte-à-faux (3,30,50) s'étend à partir d 'un bâti, et est solidaire de ce dernier, dont un bras (31,53) porte ladite deuxième plaque de condensateur (8,33,52) à son extrémité libre et en face du dos de ladite poutre en porte-à-faux (3,30,50), ladite deuxième plaque et ladite poutre en porte-à-faux constituant un condensateur (6,29,57), en ce que ladite poutre en porte-à-faux (3,30,50) possède une fréquence propre de l'ordre de 10 kHz et une constante d'élasticité effective de 4 N/m environ, une largeur de l'ordre de 100

μm, une épaisseur de 15 μm environ et une longueur de l'ordre de 1100 μm, et en ce que l'espacement entre la dite poutre en porte-à-faux (3,30,50) à son extrémité libre et ledit bras est de l'ordre de 10 μm.

3. Tête de capteur suivant la revendication 2, caractérisée en ce que ladite poutre en porte-à-faux (30) est montée sur le dessus d'un transducteur piézoélectrique (40) qui repose sur ledit bâti (31), ledit transducteur (40) étant connecté de manière à être excité par une unité d'excitation (41), en ce qu'une source de tension (42) est connectée entre les plaques de condensateur (32,33) portées par ladite poutre en porte-à-faux (30) et ledit bâti (31), respectivement, en ce que la plaque de condensateur (32) fixée à ladite poutre en porte-à-faux (30) est connectée à une entrée d'un convertisseur de courant /tension (43), et en ce que la sortie de celui-ci est connectée à un amplificateur (44) qui est lui-même connecté à ladite unité d'excitation (41).

4. Tête de capteur suivant la revendication 1, caractérisée en ce que l'intervalle entre les plaques (51,52) dudit condensateur (57) est rempli avec au moins deux matières diélectriques (54,56) ayant des constantes diélectriques différentes ($\epsilon_1$, $\epsilon_2$) et des épaisseurs relatives différentes ($s_1$ ; $s - s_1$), respectivement.

5. Tête de capteur suivant la revendication 4, caractérisée en ce que lesdites matières diélectriques (54,56) ont des constantes diélectriques ($\epsilon_1$ ; $\epsilon_2$) telles que leur rapport $\epsilon_1 : \epsilon_2$ est inférieur ou égal à 1:10 et des épaisseurs relatives ($s_1$ ; $s - s_1$) telles que le rapport $s_1 : s - s_1$ est de 1:19.

**Patentansprüche**

1. Tastkopf für atomare Kräfte, der aufweist:
zumindest einen freitragenden Träger (3, 30, 50), der an einem Ende an einem Rahmenteil (4, 39, 53) befestigt ist und der einen Wechselwirkungsteil (2, 37, 55) an einer von dem befestigten Ende entfernten Stelle für eine Wechselwirkung mit der Oberfläche einer Probe (5, 38) trägt, deren Topographie untersucht werden soll und Mittel (6, 29), um die Auslenkung des freitragenden Trägers (3, 30, 50) zu erfassen, wenn der Wechselwirkungsteil (2, 37, 55) mit der Oberfläche der untersuchten Probe (5, 38) wechselwirkt, bei welchem die Mittel (6, 29) zum Erfassen ausgelegt sind, um die Auslenkung des freitragenden Trägers (3, 30, 50) aus seiner Ruhelage in eine Änderung eines anderen elektrischen Wertes, als ein Tunnelstrom, von einem ursprünglichen Pegel für ihn umzuwandeln, dadurchgekennzeichnet, daß der Wechselwirkungsteil aus einer scharfen Spitze (2, 37, 55) besteht, die starr an dem freitragenden Träger (3, 30, 50) befestigt und in einem Abstand der Ordnung von einem Nanometer von der zu untersuchenden Oberfläche gehalten ist, daß das Mittel (6, 29) zum Erfassen als Kondensator (6, 29, 57) ausgelegt ist, der ein Paar von Kondensatorplatten (7, 8; 32, 33; 51, 52) aufweist, bei welchen eine erste (7, 32, 51) einen integralen Bestandteil mit dem freitragenden Träger (3, 30) bildet, wogegen die zweite Platte (8, 33, 52) stationär, gegenüber der ersten Platte (7, 32, 51) an einem Arm (31, 53) eines Rahmenteils angebracht ist, daß beide Platten (7, 8; 32, 33; 51, 52) des Kondensators (6, 29, 57) mit einer üblichen Kpazitätsmeßeinrichtung verbunden sind und daß das Ausgangssignal der Kapazitätsmeßeinrichtung, das eine Änderung der Kapazität des Kondensators (6, 29, 57) von einem ursprünglichen Kapazitätswert repräsentiert, über eine Rückkopplungssteuerschaltung (10; 35, 36; 43-46) zu einem z-Antrieb (12, 39) geleitet wird, um den z-Abstand der Spitze (2, 37, 55) von der Oberfläche der unter Untersuchung befindlichen Probe (5, 38) einzustellen.

2. Tastkopf nach Anspruch 1, dadurch gekennzeichnet, daß sich der freitragende Träger (3, 30, 50) von einem Rahmenteil erstreckt und mit ihm einen integralen Bestandteil bildet, bei welchem ein Arm (31, 53) die zweite Kondensatorplatte (8, 33, 52) an seinem freien Ende und dem hinteren Teil des freitragenden Trägers (3, 30, 50) gegenüberliegend trägt, wobei die zweite Platte und der freitragende Träger einen Kondensator (6, 29, 57) bilden, daß der freitragende Träger (3, 30, 50) eine Eigenfrequenz der Ordnung von 10 kHz und eine effektive Federkonstante von ungefähr 4 N/m, eine Breite der Ordnung von 100 μm, eine Dicke von ungefähr 15 μm und eine Länge der Ordnung von 1100 μm aufweist und daß der Abstand des freitragenden Trägers (3, 30, 50) an seinem freien Ende von dem Arm der Ordnung von 10 μm ist.

3. Tastkopf nach Anspruch 2, dadurch gekennzeichnet, daß der freitragende Träger (30) auf dem oberen Teil eines piezoelektrischen Wandlers (40) angebracht ist, der auf dem Rahmen (31) ruht, wobei der Wandler (40) so geschaltet ist, daß er von einer Anregeeinheit (41) angeregt wird, daß eine Spannungsquelle (42) zwischen die von dem freitragenden Träger (30) getragenen Kondensatorplatten (32, 33) bzw. dem Rahmen (31) geschaltet ist, daß die an dem freitragenden Träger (30) befestigte Kondensatorplatte (32) mit einem Eingang eines Strom/Spannung-Wandlers (43) verbunden ist und daß dessen Ausgang an einem Verstärker (44) geschaltet ist, der seinerseits an die Anregeeinheit (41) geschaltet ist.

4. Tastkopf nach Anspruch 1, dadurch gekennzeichnet daß die Lücke zwischen den Platten (51, 52) des Kondesators (57) mit zumindest zwei Dielektrika (54, 56) ausgefüllt ist, die verschiedene Dielektrizitätskonstanten ($\epsilon_1$, $\epsilon_2$) bzw. verschiedene relative Dicken ($S_1$; $S-S_1$) aufweisen.

5. Tastkopf nach Anspruch 4, dadurch gekennzeichnet, daß die Dielektrika (54, 56) solche Dielektrizitätskonstanten ($\epsilon_1$, $\epsilon_2$) aufweisen, daß ihr Verhältnis $\epsilon_1 : \epsilon_2 \leqq 1 : 10$ beträgt und solche relative Dicken ($S_1$; $S-S_1$) aufweisen, daß das Verhältnis $S_1 : S-S_1$ ⨆ $1 : 19$ beträgt.

FIG.1

FIG.2

FIG. 3

FIG.4